## Europäisches Patentamt
## European Patent Office
## Office européen des brevets

(19)

(11) Numéro de publication: **0 090 686**
**B1**

(12) FASCICULE DE BREVET EUROPEEN

(45) Date de publication du fascicule du brevet:
08.01.86

(51) Int. Cl.⁴: **H 01 L 21/76,** H 01 L 27/08

(21) Numéro de dépôt: **83400426.9**

(22) Date de dépôt: **02.03.83**

(54) **Transistor PNP fort courant faisant partie d'un circuit intégré monolithique.**

(30) Priorité: **12.03.82 FR 8204216**

(43) Date de publication de la demande:
**05.10.83 Bulletin 83/40**

(45) Mention de la délivrance du brevet:
**08.01.86 Bulletin 86/2**

(84) Etats contractants désignés:
**DE FR GB NL**

(56) Documents cités:
**FR - A - 1 538 402**
**FR - A - 1 559 607**
**FR - A - 2 154 786**

(73) Titulaire: **THOMSON-CSF, 173, Boulevard Haussmann,**
**F-75379 Paris Cedex 08 (FR)**

(72) Inventeur: **Van Zanten, François, THOMSON-CSF**
**SCPI 173, Bld. Haussmann, F-75379 Paris Cedex 08 (FR)**

(74) Mandataire: **Guérin, Michel et al, THOMSON-CSF**
**SCPI 173, Bld Haussmann, F-75379 Paris Cédex 08 (FR)**

## Description

Diverses structures ont été imaginées pour fournir des transistors PNP ou NPN pouvant laisser passer des courants relativement élevés dans des circuits intégrés. La présente invention vise plus particulièrement des structures de circuits intégrés associant des transistors NPN verticaux pouvant laisser passer des courants importants et des transistors PNP pouvant également laisser passer des courants importants et propres à commander de façon satisfaisante les transistors NPN verticaux.

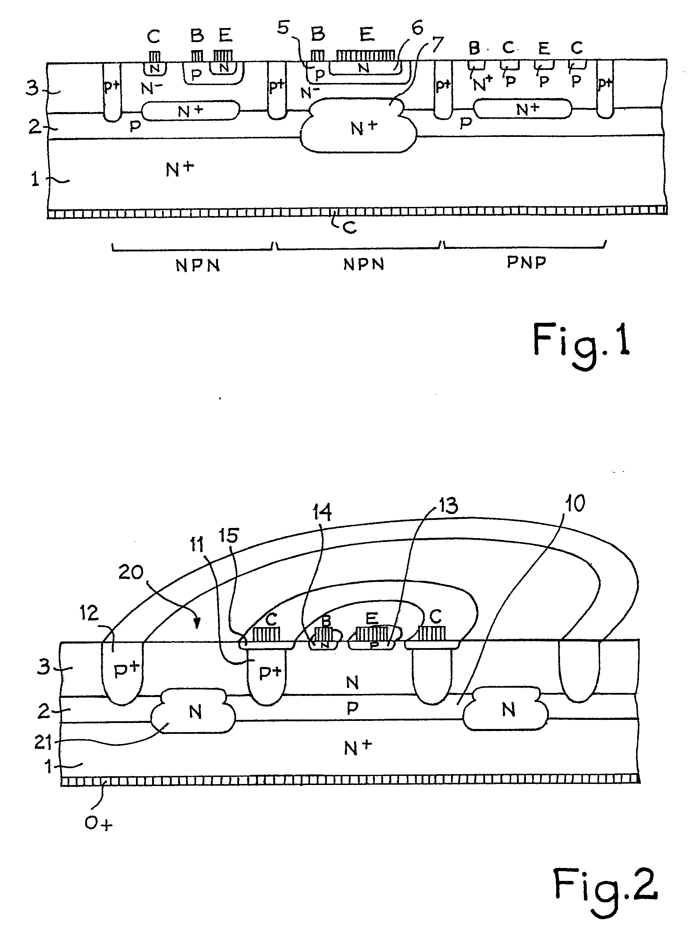

La fig. 1 représente une structure particulière de circuit intégré comprenant au-dessus d'un substrat 1 de type N$^+$ une première couche épitaxiée 2 de type P et une deuxième couche épitaxiée 3 de type N faiblement dopée. Cette structure est relativement peu courante car, habituellement, les plaquettes de circuits intégrés comportent un substrat de type P portant une couche épitaxiée de type N$^-$, c'est-à-dire une structure comprenant seulement l'équivalent des couches 2 et 3, la couche 2 correspondant alors à un substrat.

Dans les parties gauche et droite de la fig. 1 isolées par des murs de type P$^+$ atteignant la couche 2 de type P, on a représenté des transistors NPN et PNP classiques et bien connus. Les régions comprenant ces transistors ne portent aucune référence numérique; seuls ont été indiqués les types de conductivité des diverses couches et les lettres E, B et C ont été apposées en regard des métallisations respectives d'émetteur, de base et de collecteur.

L'avantage de la structure à deux épitaxies de types opposés illustrée en fig. 1 réside essentiellement dans le fait qu'elle permet d'obtenir des transistors NPN verticaux à fort courant tels que représentés dans la partie centrale de la figure. Pour ces transistors NPN, la face inférieure du substrat est métallisée et correspond au collecteur. A l'intérieur de la couche 3 de type N$^-$ est diffusée une zone 5 de type P correspondant à la base à l'intérieur de laquelle est diffusée une zone 6 de type N correspondant à l'émetteur. La couche 3 de type N$^-$ est reliée à la couche 1 de type N$^+$ par une couche enterrée 7 de type N$^+$. En fait, cette couche 7 résulte de deux diffusions/implantations successives et superposées réalisées respectivement dans le substrat 1 avant la croissance épitaxiale de la couche 2, puis dans la couche 2 avant la croissance épitaxiale de la couche 3. Les avantages de la structure de transistor NPN vertical représentée apparaissent clairement et résident essentiellement dans le fait que de tels transistors permettent de laisser passer des courants importants tout en présentant de faibles chutes ohmiques.

Néanmoins, si l'on souhaite utiliser dans une structure du type représenté en fig. 1 un transistor PNP pouvant laisser passer un courant important, par exemple pour commander un transistor de type NPN vertical, on est amené à avoir recours à une structure latérale classique telle qu'illustrée dans la partie droite de la figure. Mais, un défaut connu des transistors PNP latéraux réalisés par les technologies classiques réside dans leur inaptitude à délivrer de fortes intensités de courant (supérieures à 0,5 mA par élément). Ceci conduit à multiplier le nombre d'éléments, donc à occuper une grande surface de silicium.

Quand un transistor PNP latéral est trop sollicité en courant, deux phénomènes principaux ont lieu: d'une part, le gain en courant diminue; d'autre part, un courant parasite important est dérivé vers la borne négative des sources d'alimentation (le substrat constituant un second collecteur). Ce courant dérivé peut devenir considérable (du même ordre de grandeur que le courant utile) si, de plus, le transistor PNP se trouve dans un état de saturation. Il en résulte que de la puissance est prise sur l'alimentation et dissipée en chaleur dans la pastille semi-conductrice. Cette puissance peut être importante si le circuit fonctionne à tension élevée.

On peut considérer que le transistor PNP est associé à un transistor PNP parasite couramment appelé «transistor PNP substrat» qui présente la même base que le transistor PNP utile et un collecteur correspondant au substrat, c'est-à-dire dans le cas de la structure illustrée en fig. 1, à la couche 2; ce transistor parasite présente deux émetteurs, l'un étant l'émetteur et l'autre le collecteur du transistor PNP utile. C'est à cause de ce deuxième émetteur (le collecteur du transistor PNP utile) que l'on explique l'augmentation du courant parasite en cas de saturation du transistor PNP utile.

Il est connu, en particulier du document FR-AN° 1538402 déposé le 30 juin 1967, de réaliser deux transistors PNP et NPN, côte à côte, dans deux couches de conductivités de types opposés déposées sur un substrat. Les couches sont divisées en îlots au moyen de murs diffusés, des murs P$^+$ dans la couche N et des murs N$^+$ dans la couche P. A l'intérieur d'un caisson formé par deux îlots, et entre deux murs P$^+$ et deux murs N$^+$ est réalisé soit un transistor NPN, soit un transistor PNP. Les contacts avec les couches profondes sont pris, comme cela est connu, par des métallisations sur les faces apparentes des murs. Le transistor PNP peut commander le transistor NPN mais ces deux transistors ne travaillent pas en régime de puissance, à saturation. Si le PNP travaille à saturation, il est parasité par un transistor PNP substrat, comme cela vient d'être décrit.

Il faut donc mettre en œuvre une géométrie permettant, pour une structure donnée — substrat N, première couche P et seconde couche N — de réaliser un transistor de puissance PNP latéral qui n'ait pas de transistor parasite lorsqu'il travaille à fort courant, et, de préférence, couplé à un transistor NPN avec le meilleur rendement possible pour obtenir un gain élevé et de faibles pertes par dissipation thermique.

L'objet de la présente invention est de prévoir une application particulière de cette structure de transistor PNP comme moyen de commande d'un transistor NPN fort courant, dans un circuit intégré.

Pour atteindre cet objet, la présente invention prévoit une structure semi-conductrice comprenant un transistor PNP utilisé à la commande d'un transistor NPN, l'émetteur du transistor PNP étant relié au collecteur du transistor NPN, le collecteur du transistor PNP à la base du transistor NPN et la base du transistor PNP étant reliée à une borne de commande, dans laquelle un substrat de type $N^+$ est recouvert d'une première couche de type P, elle-même recouverte d'une deuxième couche de type $N^-$; le transistor PNP comprenant une zone centrale dans laquelle sont formées des diffusions disjointes d'émetteur et de contact de base à la surface de la deuxième couche, cette zone centrale étant entourée d'un premier mur d'isolement de type P traversant la deuxième couche, revêtu d'une métallisation de collecteur, et une couche périphérique annulaire continue enterrée de type $N^+$ située au-delà du premier mur d'isolement s'étendant transversalement du substrat $N^+$ à la deuxième couche de type N; caractérisée en ce qu'un deuxième mur d'isolement entoure l'ensemble ci-dessus énoncé et en ce que le transistor NPN est disposé entre les deux murs d'isolement et comprend une zone d'émetteur de type N à l'intérieur d'une zone de base de type P rejoignant le mur d'isolement interne, elle-même formée dans la deuxième couche de type N, une métallisation de collecteur étant formée sur la face libre de substrat et le mur d'isolement externe étant relié à la borne la plus négative du circuit.

Cet objet et ces caractéristiques et avantages ainsi que d'autres de la présente invention seront exposés plus en détail dans la description suivante de modes de réalisation particuliers faite en relation avec les figures jointes parmi lesquelles:

— la fig. 1 représente une vue en coupe d'une portion de circuit intégré destinée à soutenir l'exposé de l'état de la technique,

— la fig. 2 est une vue en coupe représentant de façon schématique la structure d'un transistor PNP,

— la fig. 3 est un schéma de circuit électrique,

— la fig. 4 est une vue en coupe illustrant schématiquement une réalisation de l'invention sous forme de circuit intégré du circuit de la fig. 3,

— la fig. 5 est une vue partielle en perspective et en coupe d'un mode de réalisation d'un circuit intégré réalisant le circuit de la fig. 3 sous forme digitée.

De façon générale, on notera qu'aucune échelle n'est respectée, ni à l'intérieur d'une même figure, ni d'une figure à l'autre, mais que, conformément à l'usage dans le domaine de la représentation des semi-conducteurs, les dimensions des diverses couches ont été arbitrairement dilatées pour faciliter la lisibilité. D'autre part, autant que faire se peut, de mêmes références ont été conservées d'une figure à l'autre pour désigner des couches et/ou éléments identiques ou similaires.

La fig. 2 représente le transistor PNP utilisé à la commande du transistor NPN. Ce transistor est formé à partir d'une structure semi-conductrice du type de celle de la fig. 1 comprenant successivement un substrat 1 de type $N^+$, une couche 2 de type P et une couche 3 de type $N^-$. Le transistor PNP est formé à l'intérieur d'une zone centrale 10 cernée par deux murs d'isolement successifs 11 et 12. Ces murs d'isolement qui entourent la zone centrale 10 sont constitués de zones diffusées de type $P^+$ traversant la couche 3 de type N pour atteindre la couche 2 de type P. Le transistor PNP selon l'invention comprend une zone d'émetteur 13 de type P formée dans la zone centrale 10 ainsi qu'une zone 14 de prise de contact de base de type $N^+$. Ces zones disjointes 13 et 14 peuvent par exemple être formées par diffusion ou implantation/diffusion. Une partie au moins des zones 13 et 14 est surmontée d'une métallisation respective d'émetteur et de base E et B. Le contact de collecteur C de ce transistor PNP vertical est repris par l'intermédiaire de la surface supérieure du mur d'isolement interne 11. Une couche diffusée 15 de type P de prise de contact est formée pour permettre le contact avec la métallisation de collecteur. Cette couche 15 de reprise de contact sera éventuellement plus large que le mur 11, présentant notamment un débordement vers la zone centrale 10 pour favoriser la récupération des porteurs minoritaires et, du même fait, améliorer le gain du transistor. Entre les deux murs d'isolement 11 et 12, se trouve une région 20 qui a un rôle d'isolement: une couche enterrée 21 de type N de forme annulaire située entre les murs d'isolement interne et externe neutralise et inverse le type de dopage de la couche P selon un anneau. On assure ainsi une conduction électrique entre les portions supérieure et inférieure (couche 3 et substrat 1) dans la zone annulaire 20. Il en résulte que la portion de la couche 2 de type P se trouvant sous la zone centrale 10 est isolée par rapport au reste de cette couche 2 de type P. En conséquence, le collecteur C du transistor PNP peut être relié à un potentiel choisi tout en maintenant la couche 2 à un potentiel négatif en dehors de la zone annulaire délimitée par la couche 21, ce qui est souhaitable pour assurer un isolement convenable des autres éléments de circuit. Cette polarisation négative de la couche 2 peut par exemple être assurée en métallisant la partie supérieure du mur d'isolement externe 12 et en la reliant à une borne négative. De même, l'anneau enterré 21 doit être à un potentiel positif. Pour ce faire, on dépose une métallisation sur la face apparente du substrat 1 et l'on connecte cette métallisation à un potentiel positif.

La couche enterrée annulaire 21 pourra être réalisée de la même façon que cela a été exposé pour la couche enterrée 7 dans le cas de la fig. 1.

On a ainsi fourni un transistor PNP ne présentant aucune possibilité de dissipation parasite même quand le courant principal entre son émetteur et son collecteur augmente ou qu'il est en état de saturation.

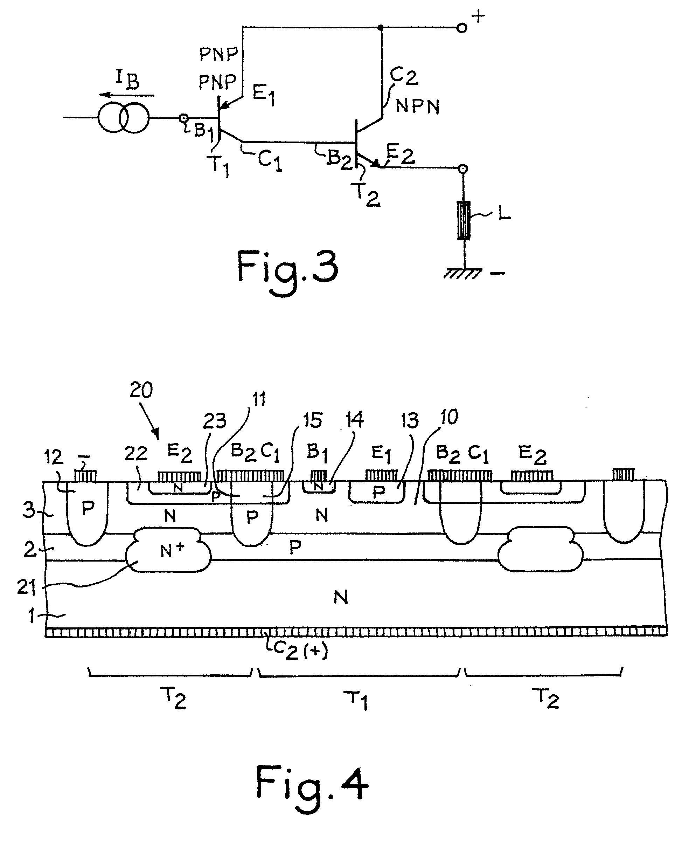

La fig. 3 représente un circuit électrique que l'on vise souvent à réaliser dans des applications pratiques et qui est réalisable de façon particulièrement simple à l'intérieur d'un circuit intégré en utilisant un transistor PNP du type décrit précédemment en relation avec la fig. 2. Le circuit de la fig. 3 comprend un transistor T2 de type NPN commandé par un transistor T1 de type PNP. Les transistors T1 et T2 ont des émetteurs, bases et collecteurs respectivement désignés par E1, B1, C1 et E2, B2, C2. La base du collecteur T2 est reliée au collecteur du transistor T1, le collecteur du transistor T2 et l'émetteur du transistor T1 sont reliés à une borne positive d'alimentation, l'émetteur du transistor T2 est connecté à la masse ou borne d'alimentation la plus négative par l'intermédiaire d'une charge L et la borne d'entrée du circuit correspond à la base B1 du transistor T1 à laquelle est de façon classique connectée une source de courant de commande.

La fig. 4 montre de façon très schématique comment une structure telle que celle de la fig. 3 s'intègre de façon particulièrement simple dans le cas où le transistor PNP T1 a la structure illustrée en fig. 2. Dans ce cas, le transistor NPN peut être disposé dans la région annulaire 20. Ainsi, pour passer de la structure de la fig. 2 à celle de la fig. 4, on a seulement prolongé vers l'extérieur la couche 15 de type P pour former dans la région annulaire 20 une couche de base 22 à l'intérieur de laquelle est formée une diffusion d'émetteur 23 de type N. On obtient alors un transistor NPN vertical analogue à celui représenté au centre de la fig. 1 qui se trouve, dans le cas de la fig. 4, périphérique par rapport au transistor central PNP T1. La métallisation de collecteur C2 de ce transistor se trouve sur la face libre du substrat.

En ce cas, tous les porteurs minoritaires injectés dans la couche épitaxiée 3 de type N au niveau de la base du transistor PNP sont récupérés dans la base du transistor NPN car celle-ci est solidaire de la couche épitaxiée 2 de type P correspondant au collecteur du transistor T1 par l'intermédiaire du mur interne 11 de type $P^+$. Il n'y a donc aucune possibilité de courant parasite vers la borne négative de la source d'alimentation.

A titre de variante, on notera que, dans les structures illustrées en fig. 2 et 4, on aurait pu, avant de procéder à l'épitaxie 3, implanter à la surface de la couche épitaxiée 2 et au niveau de la zone centrale 10, un dopant de type P, par exemple du bore, cette zone implantée étant ensuite amenée à diffuser vers le haut dans la base du transistor PNP. Ceci réduit l'épaisseur de cette base et améliore le gain et la fréquence de transition tout en réduisant la résistance de collecteur de ce transistor. Ce procédé pourra notamment être utilisé dans le cas où les murs d'isolement 11 et 12 de type P sont formés en effectuant simultanément des diffusions descendantes et montantes, les unes provenant de la surface de la tranche et les autres provenant de zones de type P implantées à la surface de la couche épitaxiée 2 de type P avant formation de la couche épitaxiée 3 de type N.

Les avantages de l'invention sont donc en résumé :

— réduction de la puissance dissipée dans la plaquette semi-conductrice du fait de l'élimination des courants dérivés vers le pôle négatif de l'alimentation,

— obtention d'un gain en courant élevé en raison du gain élevé du transistor PNP vertical,

— réduction des éventuelles rotations de phase en raison de la valeur élevée de la fréquence de transition ($f_T$) du transistor PNP vertical (cette caractéristique est importante notamment si le dispositif doit se trouver dans une boucle de contre-réaction, par exemple un régulateur),

— structure compacte utilisant une petite surface de silicium.

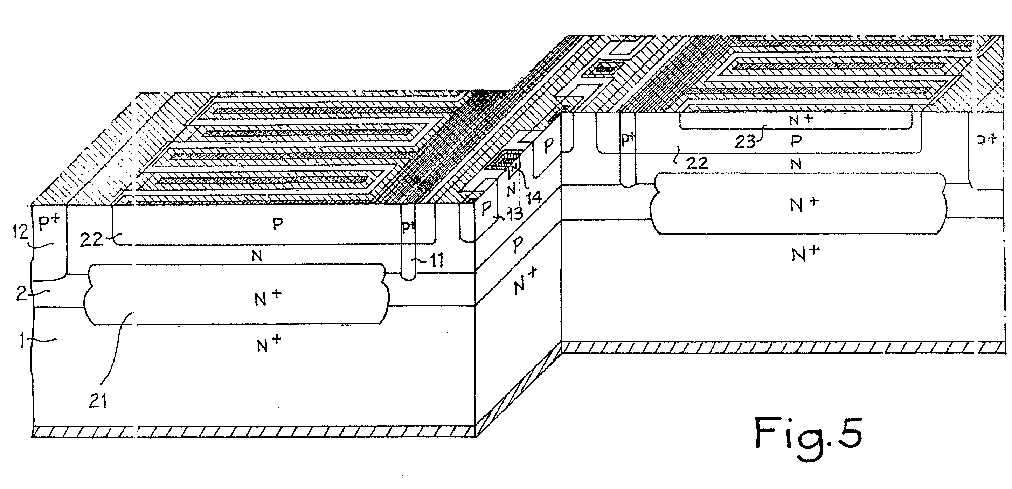

La fig. 5 est une vue en perspective représentant un mode de réalisation particulier de la présente invention sous la forme d'une structure digitée. Cette figure est représentée d'une façon qui correspond à peu près à la réalité pratique, mais il est bien entendu qu'elle n'est que partielle et que le mur d'isolement 11 entoure complètement la zone centrale tandis que le mur d'isolement 12 entoure complètement l'ensemble de la structure. Dans cette figure, de mêmes références sont utilisées qu'en fig. 4. Les limites des zones de contact entre métallisation et semi-conducteur sont désignées en pointillés. Les métallisations sont hachurées et les zones où les métallisations font contact avec une couche semi-conductrice sous-jacente sont hachurées de façon croisée. Cette figure ne sera pas décrite plus en détail car elle se lit d'elle-même et sa description correspond à celle de la fig. 4.

## Revendications

1. Structure semi-conductrice comprenant un transistor PNP utilisé à la commande d'un transistor NPN, l'émetteur du transistor PNP étant relié au collecteur du transistor NPN, le collecteur du transistor PNP à la base du transistor NPN et la base du transistor PNP étant reliée à une borne de commande, dans laquelle un substrat (1) de type $N^+$ est recouvert d'une première couche (2) de type P, elle-même recouverte d'une deuxième couche (3) de type $N^-$; le transistor PNP comprenant une zone centrale (10) dans laquelle sont formées des diffusions disjointes d'émetteur (13) et de contact de base (14) à la surface de la deuxième couche (3), cette zone centrale étant entourée d'un premier mur d'isolement (11) de type P traversant la deuxième couche, revêtu d'une métallisation de collecteur, et une couche périphérique annulaire continue enterrée (21) de type $N^+$ située au-delà du premier mur d'isolement s'étendant transversalement du substrat $N^+$ à la deuxième couche de type N; caractérisée en ce qu'un deuxième mur d'isolement (12) entoure l'ensemble ci-dessus énoncé et en ce que le transistor NPN (T2) est disposé entre les deux murs d'isolement (11 et 12) et comprend une zone d'émetteur (23) de type N à l'intérieur d'une zone de base (22) de type P rejoignant le mur d'isolement interne 11, elle-même formée dans la deuxième couche (3) de type N, une métallisation de collecteur (C2) étant formée sur la face libre du substrat et le mur d'isolement externe étant relié à la borne la plus négative du circuit.

2. Structure selon la revendication 1, caractérisée en ce qu'elle est réalisée sous forme digitée.

3. Structure selon la revendication 1, caractérisée en ce qu'elle comprend une zone surdopée (15) s'étendant à la surface du mur interne (11), cette zone surdopée débordant notamment vers l'intérieur du mur, c'est-à-dire vers la zone centrale.

4. Structure selon la revendication 1, caractérisée en ce qu'elle comprend une couche enterrée de type P dans la zone centrale à la limite entre la première couche (2) de type P et la deuxième couche (3) de type N⁻, cette couche enterrée s'étendant dans la deuxième couche de type N⁻ et réduisant son épaisseur.

**Patentansprüche**

1. Halbleiterstruktur mit einem zur Steuerung eines NPN-Transistors verwendeten PNP-Transistor, dessen Emitter an den Kollektor des NPN-Transistors, dessen Kollektor an die Basis des NPN-Transistors und dessen Basis an eine Steuerklemme angeschlossen ist, wobei ein Substrat (1) vom Typ N⁺ von einer ersten P-Schicht (2) und diese von einer zweiten Schicht (3) vom Typ N⁻ bedeckt ist und der PNP-Transistor einerseits eine zentrale Zone (10) enthält, in der getrennte Emitterdiffusionen (13) und Basiskontaktdiffusionen (14) an der Oberfläche der zweiten Schicht (3) ausgebildet sind, wobei diese zentrale Zone von einer ersten Isoliermauer (11) vom Typ P umgeben ist, die die zweite Schicht durchquert und von einer Kollektormetallisierung bedeckt ist, und andererseits eine eingebettete kontinuierliche Ringzone (21) vom Typ N⁺ enthält, die jenseits der ersten Isoliermauer liegt und sich quer vom Substrat N⁺ bis zur zweiten Schicht vom Typ N erstreckt, dadurch gekennzeichnet, dass eine zweite Isoliermauer (12) die oben erwähnte Einheit umgibt und dass der NPN-Transistor (T2) zwischen den beiden Isoliermauern (11 und 12) liegt und eine Emitterzone (23) vom Typ N innerhalb einer Basiszone (22) vom Typ P aufweist, die die innere Isoliermauer (11) berührt und in der zweiten Schicht (3) vom Typ N ausgebildet ist, wobei eine Kollektormetallisierung (C2) auf der freien Oberfläche des Substrats ausgebildet ist und die äussere Isoliermauer an die negativste Klemme des Schaltkreises angeschlossen ist.

2. Struktur nach Anspruch 1, dadurch gekennzeichnet, dass sie in verzahnter Form ausgebildet ist.

3. Struktur nach Anspruch 1, dadurch gekennzeichnet, dass sie eine Zone (15) mit Überdotierung aufweist, die sich an der Oberfläche der inneren Mauer (11) erstreckt und insbesondere nach innen, d.h. in die zentrale Zone, über die Mauer vorsteht.

4. Struktur nach Anspruch 1, dadurch gekennzeichnet, dass sie eine in die zentrale Zone an der Grenze zwischen der ersten Schicht (2) vom Typ P und der zweiten Schicht (3) vom Typ N⁻ eingebettete Schicht vom Typ P aufweist, die sich in der zweiten Schicht vom Typ N⁻ erstreckt und deren Dicke verringert.

**Claims**

1. A semiconductor structure comprising a PNP transistor used to control a NPN transistor, the emitter of the PNP transistor being connected to the collector of the NPN transistor, the collector of the PNP transistor being connected to the base of the NPN transistor and the base of the PNP transistor being connected to a control terminal, the structure comprising a substrate (1) of the N⁺ type which is covered by a first layer (2) of the P-type, the latter being covered by a second layer (3) of the N⁻ type, the PNP transistor comprising on the one hand a central zone (10) in which separate emitter and base contact diffusions (13, 14) are realized at the surface of the second layer (3), this central zone being surrounded by a first insulating wall (11) of the P-type passing through said second layer and covered by a collector metallization, and on the other hand a ring-shaped embedded peripheral layer (21) of the N⁺ type, situated beyond the first insulating wall and extending transversely from said N⁺ substrate to the second layer of the N-type, characterized in that a second insulating wall (12) surrounds the above quoted assembly and that the NPN transistor (T2) is disposed between the two insulating walls (11 and 12) and comprises an emitter zone (23) of the N-type inside a base zone (22) of the P-type in contact with the inner insulating wall (11), the base zone (22) being realized in the second layer (3) of the N-type, a collector metallization (C2) being realized on the free surface of the substrate and the outer insulating wall being connected to the most negative terminal of the circuit.

2. A structure according to claim 1, characterized in that it is realized in digited form.

3. A structure according to claim 1, characterized in that it comprises an overdoped zone (15) extending on the surface of the inner wall (11) and overflowing more especially towards the inside of the wall, i.e. towards the central zone.

4. A structure according to claim 1, characterized in that it comprises a layer of the P-type embedded in the central zone at the border between the first layer (2) of the P-type and the second layer (3) of the N⁻ type, this embedded layer extending in the second layer of the N⁻ type and reducing its thickness.

Fig.1

Fig.2

0 090 686

Fig.3

Fig.4

Fig.5

P+  12
11
22
2
1
21

P
N
N+
N+

P+
11

P
P
N
N+

P
N
13
14

p+

23  N+
22  P
N
N+
N+

p+

0 090 686